# EUROPEAN PATENT SPECIFICATION

(11) **EP 4 184 186 B1**
(45) Date of publication and mention of the grant of the patent: **24.12.2025**
(21) Application number: 21848780.9
(22) Date of filing: 08.02.2021
(51) Int. Cl.: G01R 31/28, G01R 1/04, G01R 19/00, G01R 31/319, G11C 29/56

(54) **INTELLIGENT TEST SYSTEM AND METHOD FOR MEMORY PANEL**
INTELLIGENTES TESTSYSTEM UND VERFAHREN FÜR EINE SPEICHERTAFEL
SYSTÈME DE TEST INTELLIGENT ET PROCÉDÉ POUR PANNEAU DE DONNÉES

(30) Priority: 29.07.2020 CN 202010745358
(43) Date of publication of application: 24.05.2023
(73) Proprietor: China Nuclear Power Operations Co., Ltd., Shenzhen, Guangdong 518000 (CN); China General Nuclear Power Corporation, Shenzhen, Guangdong 518028 (CN); CGN Power Co., Ltd., Shenzen, Guangdong 518028 (CN)
(72) Inventor: CHEN, Yongwei, Shenzhen, Guangdong 518000 (CN); SUO, Lingping, Shenzhen, Guangdong 518000 (CN)
(74) Representative: Westphal, Mussgnug & Partner, Patentanwälte mbB
(86) International application number: PCT/CN2021/076108
(87) International publication number: WO 2022/021837

(56) References cited:
- CN-A- 105 510 763
- CN-A- 106 950 489
- CN-A- 108 226 751
- CN-A- 112 067 970
- CN-A- 112 083 309
- CN-A- 112 083 310
- FR-B1- 2 561 480
- US-A- 4 724 379
- US-A- 5 861 743
- US-A- 5 898 703
- US-A1- 2006 114 243
- US-A1- 2013 082 731
- US-A1- 2013 342 236
- US-A1- 2013 342 236

## Description

### TECHNICAL FIELD

The invention relates to the technical field of panel testing, in particular to an intelligent testing system and method for panel.

### BACKGROUND

There are a large number of calibration panels in each overhaul of Daya Bay and Ling'ao nuclear power plants, among which the memory panels (ME panels) used have 35 pins. In the test process, it is necessary to connect their pins differently according to different performance tests. The tedious wiring is not only not intuitive and messy, but also increases the probability of wiring errors. Especially in the process of changing wiring, the probability of wiring errors will increase sharply, and the test results cannot be guaranteed to be the test results of correct wiring, which affects the reliability of the final test results of ME panels.

Publication US 2006/114243 A1 is considered to be relevant to the present application.

### SUMMARY OF THE DISCLOSURE

### TECHNICAL ISSUES

The technical problem to be solved by the present invention is to provide an intelligent testing system and method for memory panel in view of the above technical defects of the prior art.

### PROBLEM SOLUTION

### TECHNICAL SOLUTIONS

The problem underlying the present application is solved by an intelligent testing system having the features of claim 1, as well as by an intelligent test method for a memory panel having the features of claim 4.

The invention adopts the technical scheme that an intelligent test system for memory panel comprises a power supply unit, a reference signal output unit, an output detection unit, a panel socket which is pluggable mounted with a panel to be tested, a first array switch connected to first attribute pins of the panel socket, a second array switch connected to second attribute pins of the panel socket and the power supply unit, a third array switch connected to third attribute pins of the panel socket and the reference signal output unit, a fourth array switch connected to fourth attribute pins of the panel socket and the output detection unit, a control unit respectively connected to the first array switch, the second array switch, the third array switch and the fourth array switch; a communication unit respectively connected to the reference signal output unit, the output detection unit and the control unit; and a display unit connected to the communication unit, wherein,

the display unit displays virtual nodes corresponding to connection nodes of the first array switch, the second array switch, the third array switch and the fourth array switch respectively, and the display unit generates or clears connection lines among the virtual nodes when the virtual nodes are triggered, the control unit triggers the corresponding connection nodes in the first array switch, the second array switch, the third array switch and/or the fourth array switch to be connected or disconnected when the virtual nodes are triggered;

the display unit is also used for controlling the reference signal output unit to output a reference signal and obtaining a detection signal corresponding to the reference signal by the output detection unit so as to obtain a test result of the panel to be tested according to the detection signal.

The power supply unit comprises a first power supply unit for providing a first power supply voltage and a second power supply unit for providing a second power supply voltage, the first power supply and the second power supply are respectively connected to different connection nodes of the second array switch; and/or
the output detection unit comprises an output voltage detection unit for obtaining a voltage detection signal of the panel to be tested and an output current detection unit for obtaining a current detection signal of the panel to be tested, wherein the output voltage detection unit and the output current detection unit are respectively connected to different connection nodes of the fourth array switch.

Preferably, the reference signal output unit comprises a first reference signal output unit for generating a first reference voltage, a second reference signal output units for generating a second reference voltage, and a third reference output unit for generating a third reference voltage; the first reference signal output unit, the second reference signal output unit, and the third reference signal input unit are respectively connected to different connection nodes of the third array switch.

Preferably, the display unit controls the first reference voltage generated by the first reference signal output unit to be a first fixed value;
the display unit controls the second reference voltage generated by the second reference signal output unit to be a second fixed value;
the display unit controls the third reference voltage generated by the third reference signal output unit to meet a preset function.

The invention also provides an intelligent test method for a memory panel, which is applied to the intelligent test system for the memory panel, and comprises the following steps:
S1. generating virtual nodes respectively corresponding to connection nodes of the first array switch, the second array switch, the third array switch and the fourth array switch on a display interface of the display unit according to the first array switch, second array switch, third array switch and fourth array switch;
S2, triggering the virtual nodes to generate a trigger instructions, so as to generate or clear connection lines between the virtual nodes on the display interface, and controlling corresponding connection nodes in the first array switch, the second array switch, the third array switch and/or the fourth array switch to be connected or disconnected according to the trigger instruction;
S3, controlling the reference signal output unit to output a reference signal and obtaining a detection signal corresponding to the reference signal by the output detection unit;
and S4, obtaining a test result of the panel to be tested according to the detection signal.

Preferably, the intelligent test method for the memory panel of the present invention further comprises:
A1.triggering the virtual node corresponding to the second array switch, so that in the second array switch, the connection node connected to the power supply unit is respectively conducted with the connection nodes connected to the 20th pin and the fourth pin of the panel socket, and the connection nodes connected to the 15th pin and the 16th pin of the panel socket are respectively electrical grounded;
A2. triggering the virtual node corresponding to the fourth array switch, so that in the fourth array switch, the connection node connected to the 24th pin of the panel socket is conducted with the connection node connected to the output voltage detection unit, and the connection node connecting to the 18th pin of the panel socket is conducted with the connection point connected to the output current detection unit;
A3, triggering a virtual node corresponding to the third array switch, so that in the third array switch, the connection node connected to the 22nd pin of the panel socket is conducted with the connection node connected to the reference signal output unit;
A4, adjusting the reference signal to obtain the corresponding voltage detection signal and the current detection signal, and determining whether the voltage detection signal and the current detection signal meet a first preset condition, if so, determining that the test result of the panel to be tested is qualified, and if not, determining that the test result of the panel to be tested is unqualified.

Preferably, the intelligent test method for the memory panel of the present invention further comprises:
A5, triggering the virtual node corresponding to the second array switch, so that in the second array switch, the connection node connected to the power supply unit and the connection node connected to the first pin of the panel socket are instantaneously conducted;
A6. adjusting the reference signal to obtain the corresponding voltage detection signal and the current detection signal, and determining whether the voltage detection signal and the current detection signal meet a second preset condition, if so, determining that the test result of the panel to be tested is qualified, and if not, determining that the test result of the panel to be tested is unqualified.

Preferably, the intelligent test method for the memory panel of the present invention further comprises:
B5. triggering the virtual node corresponding to the second array switch, so that in the second array switch, the connection node connected to the power supply unit is conducted with the connection node connected to the tenth pin of the panel socket;
B6. obtaining the voltage detection signal and the current detection signal, and determining whether the voltage detection signal and the current detection signal meet a third preset condition, if so, determining that the test result of the panel to be tested is qualified, and if not, determining that the test result of the panel to be tested is unqualified.

Preferably, the intelligent test method for the memory panel of the present invention further comprises:
C5. triggering the virtual node corresponding to the second array switch, so that in the second array switch, the connection node connected to the power supply unit is conducted with the connection node connected to the 12th pin of the panel socket;
C6. obtaining the voltage detection signal and the current detection signal, and determining whether the voltage detection signal and the current detection signal meet a fourth preset condition, if so, determining that the test result of the panel to be tested is qualified, and if not, determining that the test result of the panel to be tested is unqualified.

Preferably, the intelligent test method for the memory panel of the present invention further comprises:
D5. triggering the virtual node corresponding to the second array switch, so that in the second array switch, the connection node connected to the power supply unit is disconnected from the connection node connected to the fourth pin of the panel socket;
D6. adjusting the reference signal to obtain the corresponding voltage detection signal and current detection signal, and determining whether the voltage detection signal and the current detection signal meet a fifth preset condition, if so, determining that the test result of the panel to be tested is qualified, and if not, determining that the test result of the panel to be tested is unqualified.

### BENEFICIAL EFFECTS OF THE INVENTION

### BENEFICIAL EFFECT

The intelligent test system and the intelligent test method for panel have the beneficial effects that the operation is convenient, the workload of the memory panel test process can be greatly reduced, and the reliability of the memory panel test is ensured.

### BRIEF DESCRIPTION OF THE DRAWINGS

### DESCRIPTION OF ATTACHED DRAWINGS

The present invention will be further described with reference to the accompanying drawings and embodiments, in which:
FIG. 1 is a logic block diagram of an embodiment of an intelligent test system for a memory panel according to the present invention;
FIG. 2 is a logic block diagram of another embodiment of an intelligent test system for a memory panel according to the present invention;
FIG. 3 is a schematic diagram of a display interface of a display unit according to an embodiment of the present invention;
FIG. 4 is a flow chart of an embodiment of a intelligent test method for a memory panel according to the present invention;
FIG. 5 is a flow chart of an embodiment of a intelligent test method for a memory panel according to the present invention;
FIG. 6 is a flow chart of another embodiment of a intelligent test method for a memory panel according to the present invention;
FIG. 7 is a flow chart of another embodiment of a intelligent test method for a memory panel according to the present invention;
FIG. 8 is a flow chart of another embodiment of an intelligent test method for a memory panel according to the present invention.

### PREFERRED EMBODIMENTS

### IMPLEMENTATION MODE OF THE INVENTION

For a clearer understanding of the technical features, objects, and effects of the present invention, specific embodiments of the present invention will be described in detail with reference to the accompanying drawings.

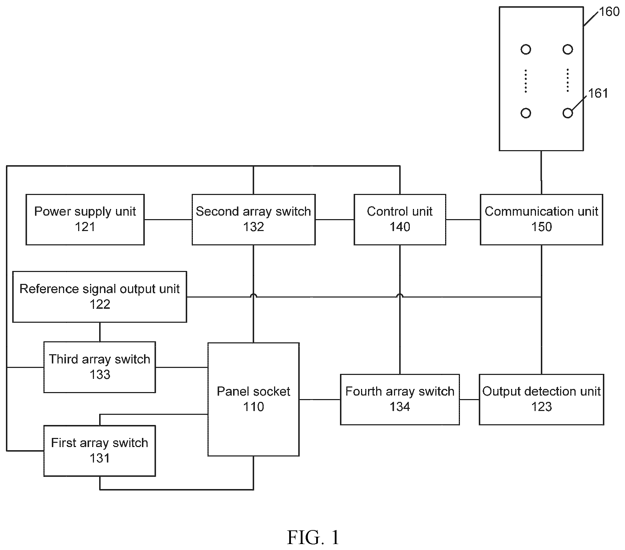

As shown in FIG. 1, an intelligent testing system for a memory panel in a first embodiment of the present invention comprises a power supply unit 121, a reference signal output unit 122, an output detection unit 123, a panel socket 110 which is pluggable mounted with the panel to be tested, a first array switch 131 connected to first attribute pins of the panel socket 110, a second array switch 132 connected to second attribute pins of the panel socket 110 and the power supply unit 121, a third array switch 133 connected to third attribute pins of the panel socket 110 and the reference signal output unit 122, a fourth array switch 134 connected to fourth attribute pins of the panel socket 110 and the output detection unit 123, a control unit 140 respectively connected to the first array switch 131, the second array switch 132, the third array switch 133, and the fourth array switch 134, a communication unit 150 respectively connected to the reference signal output unit 122, the output detection unit 123, and the control unit 140, and a display unit 160 connected to the communication unit 150; the display unit 160 displays the virtual nodes 161 respectively corresponding to the connection nodes of the first array switch 131, the second array switch 132, the third array switch 133, and the fourth array switch 134, and the display unit 160 generates or clears connection lines between the virtual nodes when the virtual nodes 161 are triggered. The control unit 140 triggers the corresponding connection nodes in the first array switch 131, the second array switch 132, the third array switch 133, and/or the fourth array switch 134 to connect or disconnect when one or more virtual node 161 are triggered; the display unit 160 is further used for controlling the reference signal output unit 122 to output a reference signal and obtaining a detection signal corresponding to the reference signal by the output detection unit 123, so as to obtain a test result of the panel to be tested according to the detection signal.

Specifically, in the test system, the panel to be tested is matched with the panel socket 110 and is installed in the panel socket 110 in a pluggable manner, and when the panel to be tested is being tested, the panel is placed on the panel socket 110 to form a test circuit of the panel to be tested. The test circuit of the panel to be tested comprises a power supply unit 121, a reference signal output unit 122, and an output detection unit 123. The power supply unit 121 is configured to supply power to the panel to be tested and other circuits during the test of the panel to be tested, the reference signal output unit 122 is configured to provide a reference signal required during the test of the panel, and the output detection unit 123 is configured to obtain a corresponding output signal when the reference signal is input during the test process of the panel. The power supply unit 121 is connected to the power supply pins, i.e., the second attribute pins, of the panel socket 110 by the second array switch 132. It can be understood that the power supply unit 121 is controlled to be turned on or off with the panel to be tested by the second array switch 132. The reference signal output unit 122 is connected to the reference signal input pins, i.e., the third attribute pins, of the panel socket 110 by the third array switch 123. It can be understood that the reference signal output unit 122 is controlled to be turned on or off with the panel to be tested by the third array switch 133. The output detection unit 123 is connected to the test signal output pins of the panel socket 110, that is, the fourth attribute pins, by the fourth array switch 134. It can also be understood that the output detection unit 123 is controlled to be connected to or disconnected from the panel to be tested by the fourth array switch 134. Meanwhile, in the process of testing the panel to be tested, some of its pins need to be connected to each other, that is, the pins of the panel to be tested that need to be connected to another one or more are controlled to be turned on or off by the first array switch 131, that is, the first array switch 131 is connected to the first attribute pins of the panel socket 110. Since the relationship between the panel socket 110 and the panel to be tested is one-to-one correspondence, the pin attribute of the panel socket 110 is determined by the circuit attribute of the panel to be tested to be connected.

During the testing process, the control unit 140 can control the first array switch 131, the second array switch 132, the third array switch 133, and the fourth array switch 134 to act as required, and the display unit 160 can control the reference signal output unit 122 by the communication unit 150 to trigger the reference signal output unit 122 outputting required reference signals. Meanwhile, the display unit 160 receives the detection signal obtained by the output detection unit 123 by the communication unit 150 and confirms the test result of the panel to be tested. Different electrical connection relations of the panel to be tested can be formed by the setting of the connection and the disconnection of each switch node in each array switch. Different electrical connection relationships correspond to the tests of different functions or indexes of the panel to be tested.

The control unit 140 is connected to the display unit 160 via the communication unit 150. The display unit 160 displays the virtual nodes 161, and the virtual nodes 161 are in one-to-one correspondence with the connection nodes of the array switches. The connection node of the array switch is considered to be the connection node of the array switch for the external circuit. When it is required to set a certain connection relationship among the endpoints of the panel socket 110, the power supply unit 121, the reference signal output unit 123 and the output detection unit 123, the virtual nodes 161 corresponding to the connection nodes of the array switches corresponding to the endpoints may be triggered, for example, two virtual nodes 161 are sequentially clicked, when the two virtual nodes 161 are not connected, a connection between the two virtual nodes 161 is generated on the display unit 160. At the same time, the control unit 140 triggers the switch node corresponding to the connection node in the array switch 130 to connect when the virtual node 161 is triggered and the two virtual nodes 161 are not connected. In this way, the electrical connection in the actual test circuit corresponding to the connection of the virtual node 161 on the display unit 160 is formed. When a certain connection relationship among the endpoints of the panel socket 110, the power supply unit 121, the reference signal output unit 122 and the output detection unit 123 needs to be disconnected, the virtual nodes 161 corresponding to the connection nodes corresponding to the endpoints may be triggered in turn. For example, two virtual nodes 161 are clicked in turn, when the two virtual nodes 161 are connected, the connection line between the two virtual nodes 161 is cleared on the display unit 160. At the same time, when the virtual node 161 is triggered, and when the two virtual nodes 161 are connected, the control unit 140 triggers the switch node corresponding to the connection node in the corresponding array switch to disconnect. In this way, the electrical connection in the actual test circuit corresponding to the connection of the virtual node 161 on the display unit 160 is disconnected.

It can be understood that, when the control unit 140 and the display unit 160 receive a trigger instruction indicating that the virtual node 161 is triggered, both the control unit 140 and the display unit 160 may judge whether there is a connection between the current virtual nodes 161, and trigger the actual array switch action and perform the action of generating or removing a connection on the display units 160 respectively according to the judgment result. The consistency between the display state of the display unit 160 and the electrical connection relationship in the actual test system is realized.

In the process of testing the panel to be tested, one or more virtual nodes 161 corresponding to the second array switch 132 are triggered to enable the power supply unit 121 to supply power to the panel to be tested; one or more virtual nodes 161 corresponding to the third array switch 133 are triggered, a reference signal is input to the panel; and one or more virtual node 162 corresponding to a fourth array switch 134 are triggered, the output detection unit 123 obtains the output signal of the panel to be tested; and determines the performance index of the panel to be tested according to the test output signal or the relationship between the test output signal and the reference signal. One or more virtual nodes 161 corresponding to the first array switch 131 are triggered, that is, the connection or disconnection relationship between the internal working pins of the panel to be tested can be realized. The corresponding relationship between each array switch and each virtual node 161 is equal to the corresponding relationship between the virtual node 161 and the connection node of the array switch as described above. The first array switch 131, the second array switch 132, the third array switch 133, and the fourth array switch 134 may be selectively set as needed.

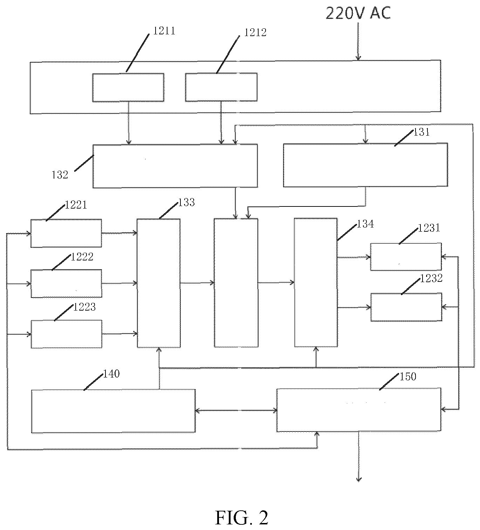

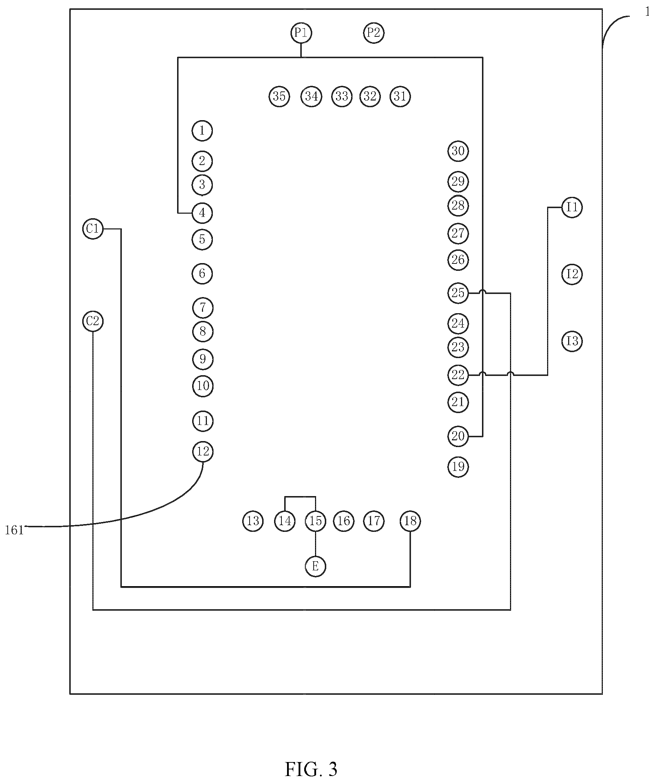

Alternatively, as shown in FIG. 2 and FIG. 3, the power supply unit 121 comprises a first power supply unit 1211 for providing a first power supply voltage and a second power supply unit 1212 for providing a second power supply voltage, the first power supply 1211 and the second power supply 1212 are respectively connected to different connection nodes of the second array switch 132. Specifically, the power supply unit 121 comprises different unit modules providing different voltage outputs, wherein the first power supply unit 1211 provides a voltage output of about 30 V, i.e., a first power supply voltage, and the second power supply unit 1212 provides a voltage output of about 48 V, i.e., a second power supply voltage. The first power supply unit 1211 and the second power supply unit 1212 do not affect each other. They may correspond to different connection nodes of the second array switch 132, which correspond to different virtual nodes 161 in the display unit 160, for example, respectively correspond to a virtual node P1 and a virtual node P2, and are respectively controlled by the second array switch 132. Meanwhile, in order to reduce power supply noise and prevent mutual crosstalk, the first power supply unit 1211 and the second power supply unit 1212 may be a power frequency transformer. In addition, in order to ensure the safety of the panel to be tested and the power supply unit 121, the power supply unit is provided with a current limiting protection function.

Alternatively, the output detection unit 123 comprises an output voltage detection unit 1231 for obtaining a voltage detection signal of the panel to be tested and an output current detection unit 1232 for obtaining a current detection signal of the panel to be tested. The output voltage detection unit 1231 and the output current detection unit 1232 are respectively connected to different connection nodes of the fourth array switch 134. That is, in the process of testing the panel to be tested, the voltage detection signal and the current detection signal may be respectively detected to analyze the performance of the panel to be tested. The corresponding voltage detection signal may be acquired by the output voltage detection unit 1231 and the corresponding current detection signal may be acquired by the output current detection unit 1232. The output voltage detection unit 1231 and the output current detection unit 1232 respectively correspond to different connection nodes of the fourth array switch 134, therefore, the output voltage detection unit 1231 and the output current detection unit 1232 also correspond to different virtual nodes in the display unit, for example, respectively correspond to the virtual nodes C1 and C2, which are respectively controlled by the fourth array switch 134.

In an embodiment, the output voltage detection unit 1231 includes a 24-bit high-precision analog-digital conversion chip with a high-stability reference to protect the measurement signal from entering by mistake under high voltage, and the chip allows the voltage detection signal of 60VDC to enter a signal conditioning circuit at most. The conditioning circuit conditions the voltage detection signal to a voltage suitable for the ADC measurement chip by a high-performance operational amplifier and a metal foil resistor, and then the voltage is directly measured by the ADC. The measurement rate can be set, and the maximum acquisition rate is 100 S/s. And a Microcontroller unit is arranged in that output voltage detection unit to control the acquisition process of the voltage detection signal. In order to prevent signal crosstalk, a photoelectric isolation chip is used between the output voltage detection unit 1231 and the communication unit 150 for data communication.

In an embodiment, the output current detection unit 1232 includes a 24-bit high-precision analog-digital conversion chip with high-stability reference to perform current limiting protection on the measured current signal, that is, the maximum current is not higher than 30mA, to prevent the subsequent circuit from being damaged by the large current. At that same time, the current is converted into voltage by a 250-ohm resistor and then enters a signal conditioning circuit, the conditioning circuit includes a high-performance operational amplifier and a metal foil resistor, an input signal is condition to a voltage suitable for an ADC measuring chip, and then the voltage is directly measured by the ADC. The measurement rate can be set, and the maximum acquisition rate is 100 S/s. The output current detection unit 1232 is provided with a Microcontroller unit to control the current detection signal acquisition process. In order to prevent signal crosstalk, a photoelectric isolation chip is used between the output current detection unit 1232 and the communication unit 150 for data communication.

Alternatively, the reference signal output unit 122 comprises a first reference signal output unit 1221 for generating a first reference voltage, a second reference signal output units 1222 for generating a second reference voltage, and a third reference output unit 1223 for generating a third reference voltage; the first reference signal output units 1221, the second reference signal output units 1222 and the third reference signal output units 1223 are connected to different connection nodes of the third array switch 133, respectively. That is, the reference signal output units 122 include a first reference signal output unit 1221, a second reference signal output unit 1222, and a third reference signal input unit 1223, which three are independently powered and respectively used for providing three different reference voltage outputs, and each of the first, second, and third reference signal input units has an output short-circuit protection function. A 16-bit high precision digital-to-analog conversion chip with high stability and low temperature drift voltage reference is used in the circuit, to condition the output signal of the digital-to-analog chip. The conditioning circuit uses a high-performance operational amplifier and a metal foil resistor. After conditioning, the output voltage is output after current limiting protection, and the allowable output current is not higher than 10mA. It can obtain the output reference voltage by the output port of each reference signal output unit. Each reference signal output unit is provided with a Microcontroller unit to control the output process of each reference voltage, and in order to prevent signal crosstalk, One or more photoelectric isolation chips are used between each reference signal output unit and the communication unit 150 for data communication. The first reference signal output units 1221, the second reference signal output units 1222 and the third reference signal output units 1223 respectively correspond to different connection nodes of the third array switch 133, therefore, the first reference signal output units 1221, the second reference signal output units 1222 and the third reference signal output units 1223 also correspond to different virtual nodes 161 in the display unit 160, for example, respectively correspond to virtual nodes I1, I2 and i3, which are respectively controlled by the third array switches 134.

Alternatively, the display unit 160 controls the first reference voltage generated by the first reference signal output unit 1221 to be a first fixed value, and controls the second reference voltage generated by the second reference signal output unit 1222 to be a second fixed value; the display unit 160 controls the third reference voltage generated by the third reference signal output unit 1223 to meet a preset function. Wherein the first reference voltage and the second reference voltage can be fixed values, and the range of the first reference voltage and the second reference voltage is 0-6 V. The third reference voltage is a function voltage, that is, the third reference signal output unit 1231 can output a ramp voltage under the control of the display unit 160, and the maximum output rate is 100 S/s.

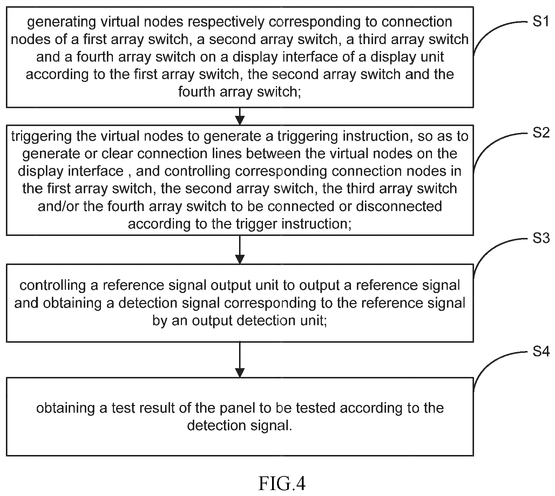

In addition, as shown in FIG. 4, an intelligent test method for a memory panel according to the present invention is applied to the above intelligent test system for a memory panel, and comprises:
S1, generating virtual nodes respectively corresponding to connection nodes of a first array switch, a second array switch, a third array switch and a fourth array switch on a display interface of a display unit according to the first array switch, the second array switch and the fourth array switch;
S2, triggering the virtual nodes to generate a triggering instruction, so as to generate or clear connection lines between the virtual nodes on the display interface , and controlling corresponding connection nodes in the first array switch, the second array switch, the third array switch and/or the fourth array switch to be connected or disconnected according to the trigger instruction;
S3, controlling a reference signal output unit to output a reference signal and obtaining a detection signal corresponding to the reference signal by an output detection unit;
and S4, obtaining a test result of the panel to be tested according to the detection signal.

Specifically, according to the intelligent test system for the memory panel described above, the connection relationship between the virtual nodes is formed by triggering the virtual nodes, and the corresponding connection lines are generated, and at the same time, each array switch corresponding to the virtual node acts according to the trigger instruction of the virtual node to form the connection relationship between the corresponding connection nodes, so as to form the final connection circuit connection relationship. Based on the connection relationship of the circuit, the reference signal output unit is controlled to output a reference signal, and a detection signal corresponding to the reference signal is obtained by the output detection unit; and a test result of the panel to be tested is obtained according to the detection signal, and the test of the panel to be tested is completed. Various operations are specifically carried out according to the intelligent test system for the memory panel so as to realize the test of different panels to be tested.

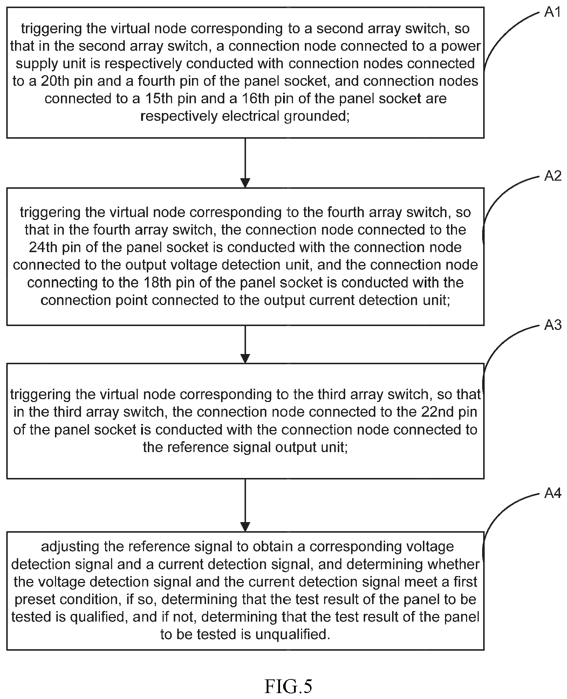

Alternatively, as shown in FIG. 5, a intelligent test method for a memory panel according to the present invention further comprises:
A1, triggering the virtual node corresponding to a second array switch, so that in the second array switch, a connection node connected to a power supply unit is respectively conducted with connection nodes connected to a 20th pin and a fourth pin of the panel socket, and connection nodes connected to a 15th pin and a 16th pin of the panel socket are respectively electrical grounded;
A2. triggering the virtual node corresponding to the fourth array switch, so that in the fourth array switch, the connection node connected to the 24th pin of the panel socket is conducted with the connection node connected to the output voltage detection unit, and the connection node connecting to the 18th pin of the panel socket is conducted with the connection point connected to the output current detection unit;
A3, triggering the virtual node corresponding to the third array switch, so that in the third array switch, the connection node connected to the 22nd pin of the panel socket is conducted with the connection node connected to the reference signal output unit;
A4, adjusting the reference signal to obtain a corresponding voltage detection signal and a current detection signal, and determining whether the voltage detection signal and the current detection signal meet a first preset condition, if so, determining that the test result of the panel to be tested is qualified, and if not, determining that the test result of the panel to be tested is unqualified.

Specifically, the automatic state test can be performed on the ME panel according to the following process: the conductive connection between the pin T20 and the pin T4 of the ME panel and the power supply unit is realized by triggering the virtual node to realize the + 28 V voltage input; the pin T15 and the pin T16 of the ME panel are electrical grounded, and the pin T22 of the ME panel is connected to the reference signal output unit to receive the reference signal. The output voltage detection unit is in conduction connection with the pin T24 of the ME panel to realize the acquisition of a voltage detection signal, and the output current detection unit is in conduction connection with the pin T18 of the ME panel to realize the acquisition of a current detection signal. In that test process, the reference signal output unit is adjusted to enable the reference signal to change according to a certain rule, a corresponding current detection signal and a corresponding voltage detection signal are acquired, and that whether the output accuracy of the ME panel meets the requirement is confirmed according to the current detection signal and the voltage detection signal, namely, that whether the voltage detection signals and the current detection signals meet a first preset condition. When the reference signal is a voltage signal of 1V to 5V, the current detection signal and the voltage detection signal are respectively a voltage signal of 1V to 5V and a current signal of 4mA to 20mA. The accuracy of the voltage detection signal is required that the deviation be not larger than 0.5%, and the accuracy of the current detection signal is required that the deviation be not larger than 3%. For details, please refer to the following table:

| reference signal (5V) | voltage detection signal | result | current detection signal | result |
|---|---|---|---|---|
| 0% | 1.000V | qualified | 4.000mA | qualified |
| 25% | 2.000V | qualified | 8.000mA | qualified |
| 50% | 3.000V | qualified | 12.000mA | qualified |
| 75% | 4.000V | qualified | 16.000mA | qualified |
| 100% | 5.000V | qualified | 20.000mA | qualified |

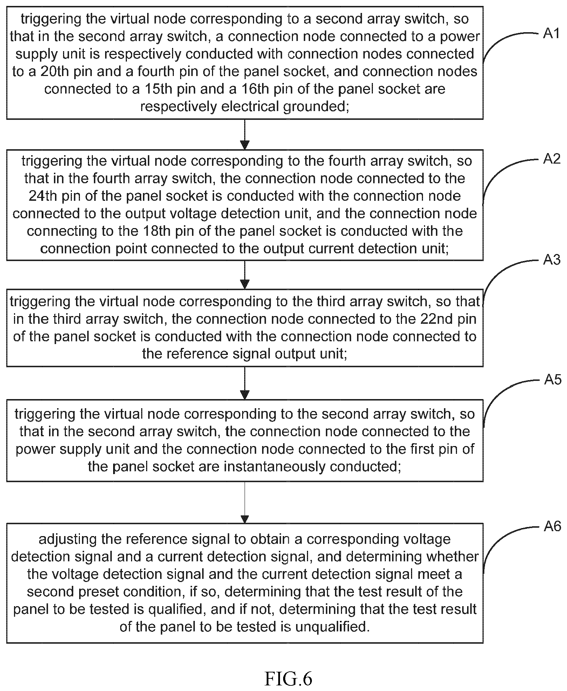

Alternatively, as shown in FIG. 6, a intelligent test method for a memory panel according to the present invention further comprises:
A5. triggering the virtual node corresponding to the second array switch, so that in the second array switch, the connection node connected to the power supply unit and the connection node connected to the first pin of the panel socket are instantaneously conducted;
A6, adjusting the reference signal to obtain a corresponding voltage detection signal and a current detection signal, and determining whether the voltage detection signal and the current detection signal meet a second preset condition, if so, determining that the test result of the panel to be tested is qualified, and if not, determining that the test result of the panel to be tested is unqualified.

Specifically, on the basis of the above, switching to the manual state test of the ME panel according to the following process, the conductive connection between the pin T20 and the pin T4 of the ME panel and the power supply unit, which is realized by triggering the virtual node, is maintained to realize + 28 V voltage input, and the pin T15 and the pin T16 of the ME panel are electrical grounded. The pin T22 of the ME panel is connected to the reference signal output unit to receive the reference signal, the output voltage detection unit is in conduction connection with the pin T24 of the ME panel to realize the acquisition of a voltage detection signal, and the output current detection unit is in conduction connection with the pin T18 of the ME panel to realize the acquisition of a current detection signal. The pin T1 of the ME panel is triggered to be instantaneously conducted with the power supply unit by triggering the virtual node, and the instantaneous conduction can also be understood as instantaneous conduction, that is, the power supply is cut off after the pin T1 of the ME panel is quickly powered on and triggered. In that test process, the reference signal output unit is adjusted to enable the reference signal to change according to a certain rule, a corresponding current detection signal and a corresponding voltage detection signal are acquired, and that whether the output of the ME panel meet the requirement is confirmed according to the current detection signal and the voltage detection signal, namely, that whether the voltage detection signals and the current detection signals meet a second preset condition. The current detection signal and the voltage detection signal at this time should not change with the change of the reference signal, and are fixed values. That is, when the current detection signal and the voltage detection signal do not change with the change of the reference signal, the test result of the panel to be tested is determined to be qualified, and if the current detection signal and the voltage detection signal change, the test result of the panel to be tested is determined to be unqualified.

Alternatively, as shown in FIG. 6, a intelligent test method for a memory panel according to the present invention further comprises:
B5. triggering the virtual node corresponding to the second array switch, so that in the second array switch, the connection node connected to the power supply unit is conducted with the connection node connected to the tenth pin of the panel socket;
B6. obtaining a voltage detection signal and a current detection signal, and confirming whether the voltage detection signal and the current detection signal meet a third preset condition, if so, determining that the test result of the panel to be tested is qualified, and if not, determining that the test result of the panel to be tested is unqualified.

Specifically, on the basis of the above, switching to the automatic addition state test of the ME panel according to the following process: the conductive connection between the pin T20 and the pin T4 of the ME panel and the power supply unit, which are realized by triggering the virtual nodes, is maintained to realize + 28 V voltage input, and the pin T15 and the pin T16 of the ME panel are electrical grounded. The pin T22 of the ME panel connected to the reference signal output unit to receive the reference signal, the output voltage detection unit is in conduction connection with the pin T24 of the ME panel to realize the acquisition of a voltage detection signal, and the output current detection unit is in conduction connection with the pin T18 of the ME panel to realize the acquisition of a current detection signal. The pin T10 of the ME panel is connected to the power supply unit by triggering the virtual node to realize + 28 V voltage input; and in the test process, the reference signal output unit enables a reference signal to be input fixedly and obtains a corresponding current detection signal and a corresponding voltage detection signal, confirming whether the output of the ME panel meets the requirement according to the current detection signal and the voltage detection signal, that is, whether the voltage detection signal and the current detection signal meet a third preset condition. The current detection signal and the voltage detection signal at this time should be automatically increased. That is, when the current detection signal and the voltage detection signal are automatically increased, the test result of the panel to be tested is determined to be qualified, and if the current detection signal and the voltage detection signal are not automatically increased, the test result of the panel to be tested is determined to be unqualified.

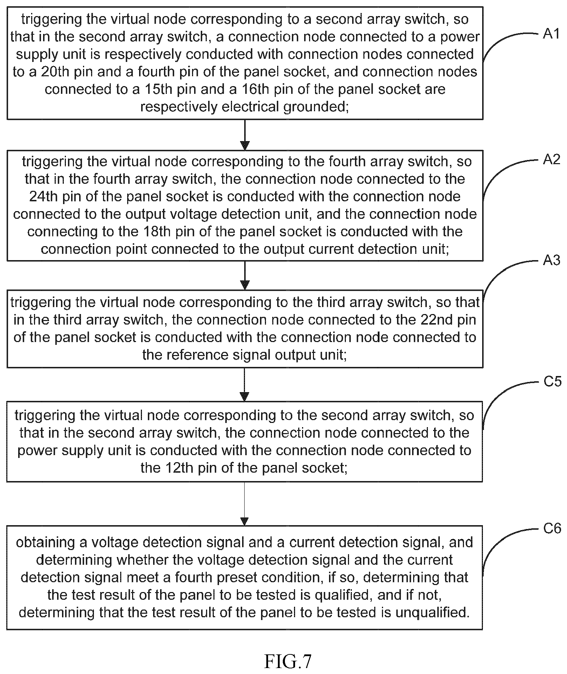

Alternatively, as shown in FIG. 7, a intelligent test method for a memory panel according to the present invention further comprises:
C5. triggering the virtual node corresponding to the second array switch, so that in the second array switch, the connection node connected to the power supply unit is conducted with the connection node connected to the 12th pin of the panel socket;
C6, obtaining a voltage detection signal and a current detection signal, and determining whether the voltage detection signal and the current detection signal meet a fourth preset condition, if so, determining that the test result of the panel to be tested is qualified, and if not, determining that the test result of the panel to be tested is unqualified.

Specifically, on the basis of the above, switching to the automatic reduction state test of the ME panel according to the following process. The conductive connection between the pin T20 and the pin T4 of the ME panel and the power supply unit , which is realized by triggering the virtual node, is maintained to realize + 28 V voltage input, the pin T15 and the pin T16 of the ME panel are electrical grounded, The pin T22 of the ME Panel is connected to the reference signal output unit to receive the reference signal, the output voltage detection unit is in conduction connection with the pin T24 of the ME panel to realize the acquisition of a voltage detection signal, and the output current detection unit is in conduction connection with the pin T18 of the ME panel to realize the acquisition of a current detection signal. the pin T12 of the ME panel is connected to the power supply unit by triggering the virtual node to realize + 28 V voltage input; and in the test process, the reference signal output unit enables a reference signal to be input fixedly and obtains a corresponding current detection signal and a corresponding voltage detection signal, Confirming whether the output of the ME panel meets the requirement according to the current detection signal and the voltage detection signal, that is, whether the voltage detection signal and the current detection signal meet a fourth preset condition. At this time, the current detection signal and the voltage detection signal should be automatically reduced. That is, when the current detection signal and the voltage detection signal are automatically reduced, the test result of the panel to be tested is determined to be qualified, and if the current detection signal and the voltage detection signal are not automatically reduced, the test result of the panel to be tested is determined to be unqualified.

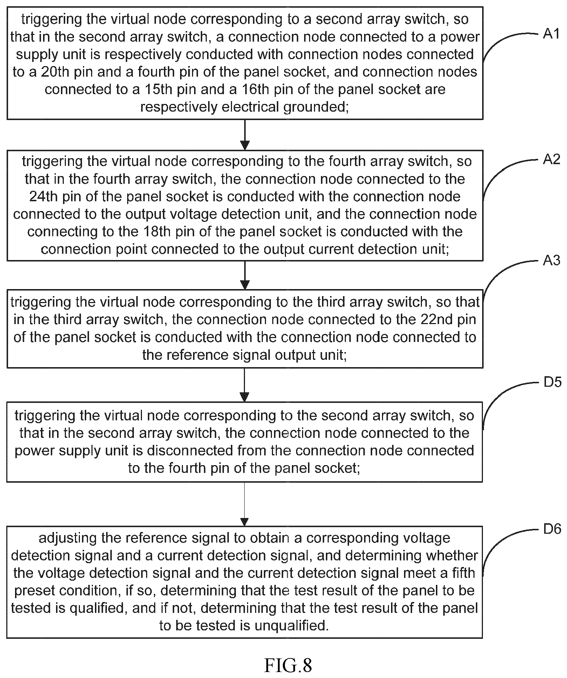

Alternatively, as shown in FIG. 8, a intelligent test method for a memory panel according to the present invention further comprises:
D5. triggering the virtual node corresponding to the second array switch, so that in the second array switch, the connection node connected to the power supply unit is disconnected from the connection node connected to the fourth pin of the panel socket;
D6, adjusting the reference signal to obtain a corresponding voltage detection signal and a current detection signal, and determining whether the voltage detection signal and the current detection signal meet a fifth preset condition, if so, determining that the test result of the panel to be tested is qualified, and if not, determining that the test result of the panel to be tested is unqualified.

Specifically, on the basis of the above, switching to the automatic and manual state switching test of the ME panel according to the following process. the conductive connection between the pin T20 of the ME panel and the power supply unit ,which are realized by triggering the virtual node, is maintained to realize the connection of + 28 V voltage input, the pins T15 and T16 of the ME panel are electrical grounded, the pin T22 of the ME panel is connected to the reference signal output unit to receive the reference signal, the output voltage detection unit is in conduction connection with the pin T24 of the ME panel to realize the acquisition of a voltage detection signal, and the output current detection unit is in conduction connection with the pin T18 of the ME panel to realize the acquisition of a current detection signal. By triggering the virtual node, the conductive connection between the pin T4 of the ME panel and the power supply unit is realized, and the disconnection of + 28V voltage input is realized. In the testing process, when the reference signal is changed, the output voltage detection unit and the output current detection unit obtain the corresponding current detection signal and voltage detection signal, and determines whether the output of the ME panel meets the requirement, that is, whether the voltage detection signal and the current detection signal meet a fifth preset condition. The current detection signal and the voltage detection signal should not change at this time. That is, when the current detection signal and the voltage detection signal do not change, the test result of the panel to be tested is determined to be qualified, and when the current detection signal and the voltage detection signal change, the test result of the panel to be tested is determined to be unqualified.

It can also be understood that whether the test result of the panel to be tested is qualified or unqualified in the test process is the judgment of a specific test item, and if the test result is qualified, it means that the test item is qualified, and if the test is unqualified, it means that the test result of the test item is unqualified.

## Claims

1. An intelligent test system for a memory panel, comprising: a power supply unit (121), a reference signal output unit (122), an output detection unit (123), a panel socket (110) which is pluggable mounted with the panel to be tested, a first array switch (131) connected to first attribute pins of the panel socket (110), and a second array switch (132) connected to second attribute pins of the panel socket (110) and the power supply unit (121); a third array switch (133) connected to third attribute pins of the panel socket (110) and the reference signal output unit (122), a fourth array switch (134) connected to fourth attribute pins of the panel socket (110) and the output detection unit (123), and a control unit (140) respectively connected to the first array switch (131), the second array switch (132), the third array switch (133) and the fourth array switch (134); a communication unit (150) respectively connected to the reference signal output unit (122), the output detection unit (123) and the control unit (140), and a display unit (160) connected to the communication unit (150), wherein
the display unit (160) displays virtual nodes (161) corresponding to connection nodes of the first array switch (131), the second array switch (132), the third array switch (133) and the fourth array switch (134) respectively, and the display unit (160) generates or clears connection lines between the virtual nodes when the virtual nodes (161) are triggered, the control unit (140) triggers the corresponding connection nodes in the first array switch (131), the second array switch (132), the third array switch (133) and/or the fourth array switch (134) to be connected or disconnected when the virtual node (161) is triggered;
the display unit (160) is also used for controlling the reference signal output unit (122) to output a reference signal and obtaining a detection signal corresponding to the reference signal by the output detection unit (123) so as to obtain a test result of the panel to be tested according to the detection signal,
**characterised in that**
the power supply unit (121) comprises a first power supply unit (1211) for providing a first power supply voltage and a second power supply unit (1212) for providing a second power supply voltage, the first power supply (1211) and the second power supply (1212) are respectively connected to different connection nodes of the second array switch (132); and/or
the output detection unit (123) comprises an output voltage detection unit (1231) for obtaining a voltage detection signal of the panel to be tested and an output current detection unit (1232) for obtaining a current detection signal of the panel to be tested, wherein the output voltage detection unit (1231) and the output current detection unit (1232) are respectively connected to different connection nodes of the fourth array switch (134).

2. The intelligent test system for a memory panel according to claim 1, wherein
the reference signal output unit (122) comprises a first reference signal output unit (1221) for generating a first reference voltage, a second reference signal output unit (1222) for generating a second reference voltage, and a third reference output unit (1223) for generating a third reference voltage;
the first reference signal output unit (1221), the second reference signal output unit (1222), and the third reference signal input unit (1223) are respectively connected to different connection nodes of the third array switch (133).

3. The intelligent test system for a memory panel according to claim 2, wherein
the display unit (160) controls the first reference voltage generated by the first reference signal output unit (1221) to be a first fixed value;
the display unit (160) controls the second reference voltage generated by the second reference signal output unit (1222) to be a second fixed value;
the display unit (160) controls the third reference voltage generated by the third reference signal output unit (1223) to meet a preset function.

4. An intelligent test method for a memory panel, applied to the intelligent test system for a memory panel according to any one of claims 1 to 3, comprising:
S1, generating virtual nodes (161) respectively corresponding to connection nodes of the first array switch (131), the second array switch (132), the third array switch (133) and the fourth array switch (134) on a display interface of the display unit (160) according to the first array switch (131), second array switch (132), third array switch (133) and fourth array switch (134);
S2, triggering the virtual nodes (161) to generate a trigger instruction, so as to generate or clear connection lines between the virtual nodes (161) on the display interface, and controlling corresponding connection nodes in the first array switch (131), the second array switch (132), the third array switch (133) and/or the fourth array switch (134) to be connected or disconnected according to the trigger instruction;
S3, controlling the reference signal output unit (122) to output a reference signal and obtaining a detection signal corresponding to the reference signal by the output detection unit (123);
and S4, obtaining a test result of the panel to be tested according to the detection signal.

5. The intelligent test method for a memory panel according to claim 4, wherein the test method further comprises:
A1, triggering the virtual node (161) corresponding to the second array switch (132), so that in the second array switch (132), the connection node connected to the power supply unit (121) is respectively conducted with the connection nodes connected to the 20th pin and the fourth pin of the panel socket, and the connection nodes connected to the 15th pin and the 16th pin of the panel socket are respectively electrical grounded;
A2, triggering the virtual node corresponding to the fourth array switch (134), so that in the fourth array switch (134), the connection node connected to the 24th pin of the panel socket is conducted with the connection node connected to the output voltage detection unit (1231), and the connection node connecting to the 18th pin of the panel socket is conducted with the connection point connected to the output current detection unit (1232);
A3, triggering a virtual node (161) corresponding to the third array switch (133), so that in the third array switch (133), the connection node connected to the 22nd pin of the panel socket is conducted with the connection node connected to the reference signal output unit (122);
A4, adjusting the reference signal to obtain the corresponding voltage detection signal and the current detection signal, and determining whether the voltage detection signal and the current detection signal meet a first preset condition, if so, determining that the test result of the panel to be tested is qualified, and if not, determining that the test result of the panel to be tested is unqualified.

6. The intelligent test method for a memory panel according to claim 5, wherein the test method further comprises:
A5, triggering the virtual node corresponding to the second array switch, so that in the second array switch, the connection node connected to the power supply unit and the connection node connected to the first pin of the panel socket are instantaneously conducted;
A6, adjusting the reference signal to obtain the corresponding voltage detection signal and the current detection signal, and determining whether the voltage detection signal and the current detection signal meet a second preset condition, if so, determining that the test result of the panel to be tested is qualified, and if not, determining that the test result of the panel to be tested is unqualified.

7. The intelligent test method for a memory panel according to claim 5, wherein the test method further comprises:
B5, triggering the virtual node (161) corresponding to the second array switch (132), so that in the second array switch (132), the connection node connected to the power supply unit (121) is conducted with the connection node connected to the tenth pin of the panel socket;
B6, obtaining the voltage detection signal and the current detection signal, and determining whether the voltage detection signal and the current detection signal meet a third preset condition, if so, determining that the test result of the panel to be tested is qualified, and if not, determining that the test result of the panel to be tested is unqualified.

8. The intelligent test method for a memory panel according to claim 5, wherein the test method further comprises:
C5, triggering the virtual node (161) corresponding to the second array switch (132), so that in the second array switch (132), the connection node connected to the power supply unit is conducted with the connection node connected to the 12th pin of the panel socket;
C6, obtaining the voltage detection signal and the current detection signal, and determining whether the voltage detection signal and the current detection signal meet a fourth preset condition, if so, determining that the test result of the panel to be tested is qualified, and if not, determining that the test result of the panel to be tested is unqualified.

9. The intelligent test method for a memory panel according to claim 5, wherein the test method further comprises:
D5, triggering the virtual node (161) corresponding to the second array switch (132), so that in the second array switch (132), the connection node connected to the power supply unit (121) is disconnected from the connection node connected to the fourth pin of the panel socket;
D6, adjusting the reference signal to obtain the corresponding voltage detection signal and current detection signal, and determining whether the voltage detection signal and the current detection signal meet a fifth preset condition, if so, determining that the test result of the panel to be tested is qualified, and if not, determining that the test result of the panel to be tested is unqualified.

## Patentansprüche

1. Intelligentes Testsystem für ein Speicherpanel, umfassend:
eine Stromversorgungseinheit (121), eine Referenzsignalausgabeeinheit (122), eine Ausgabedetektionseinheit (123), einen Panel-Sockel (110), der mit dem zu testenden Panel steckbar verbunden ist, einen ersten Array-Schalter (131), der mit ersten Attribut-Pins des Panel-Sockels (110) verbunden ist, und einen zweiten Array-Schalter (132), der mit zweiten Attribut-Pins des Panel-Sockels (110) und der Stromversorgungseinheit (121) verbunden ist; einen dritten Array-Schalter (133), der mit dritten Attributpins der Panel-Buchse (110) und der Referenzsignal-Ausgabeeinheit (122) verbunden ist, einen vierten Array-Schalter (134), der mit vierten Attributpins der Panel-Buchse (110) und der Ausgangsdetektionseinheit (123) verbunden ist, und eine Steuereinheit (140), die jeweils mit dem ersten Array-Schalter (131), dem zweiten Array-Schalter (132), dem dritten Array-Schalter (133) und dem vierten Array-Schalter (134); eine Kommunikationseinheit (150), die jeweils mit der Referenzsignalausgabeeinheit (122), der Ausgabedetektionseinheit (123) und der Steuereinheit (140) verbunden ist, und eine Anzeigeeinheit (160), die mit der Kommunikationseinheit (150) verbunden ist, wobei
die Anzeigeeinheit (160) virtuelle Knoten (161) anzeigt, die den Verbindungsknoten des ersten Array-Schalters (131), dem zweiten Array-Schalter (132), dem dritten Array-Schalter (133) und dem vierten Array-Schalter (134) anzeigt, und die Anzeigeeinheit (160) Verbindungslinien zwischen den virtuellen Knoten erzeugt oder löscht, wenn die virtuellen Knoten (161) ausgelöst werden, wobei die Steuereinheit (140) die entsprechenden Verbindungsknoten im ersten Array-Schalter (131), dem zweiten Array-Schalter (132), dem dritten Array-Schalter (133) und/oder dem vierten Array-Schalter (134), um verbunden oder getrennt zu werden, wenn der virtuelle Knoten (161) ausgelöst wird;
die Anzeigeeinheit (160) auch dazu verwendet wird, die Referenzsignalausgabeeinheit (122) so zu steuern, dass sie ein Referenzsignal ausgibt, und ein dem Referenzsignal entsprechendes Erfassungssignal durch die Ausgangs-Erfassungseinheit (123) zu erhalten, um ein Testergebnis des zu testenden Panels entsprechend dem Erfassungssignal zu erhalten, **dadurch gekennzeichnet, dass** die Stromversorgungseinheit (121) eine erste Stromversorgungseinheit (1211) zum Bereitstellen einer ersten Versorgungsspannung und eine zweite Stromversorgungseinheit (1212) zum Bereitstellen einer zweiten Versorgungsspannung umfasst, wobei die erste Stromversorgung (1211) und die zweite Stromversorgung (1212) jeweils mit unterschiedlichen Verbindungsknoten des zweiten Array-Schalters (132) verbunden sind; und/oder
die Ausgangsdetektionseinheit (123) eine Ausgangsspannungsdetektionseinheit (1231) zum Erhalten eines Spannungserfassungssignals der zu testenden Platte und eine Ausgangsstromerfassungseinheit (1232) zum Erhalten eines Stromerfassungssignals der zu testenden Platte umfasst, wobei die Ausgangsspannungserfassungseinheit (1231) und die Ausgangsstromerfassungseinheit (1232) jeweils mit unterschiedlichen Verbindungsknoten des vierten Array-Schalters (134) verbunden sind.

2. Intelligentes Testsystem für ein Speicherpanel gemäß Anspruch 1, wobei
die Referenzsignalausgabeeinheit (122) eine erste Referenzsignalausgabeeinheit (1221) zum Erzeugen einer ersten Referenzspannung, eine zweite Referenzsignalausgabeeinheit (1222) zum Erzeugen einer zweiten Referenzspannung und eine dritte Referenzausgabeeinheit (1223) zum Erzeugen einer dritten Referenzspannung umfasst;
wobei die erste Referenzsignalausgabeeinheit (1221), die zweite Referenzsignalausgabeeinheit (1222) und die dritte Referenzsignalausgabeeinheit (1223) jeweils mit verschiedenen Verbindungsknoten des dritten Array-Schalters (133) verbunden sind.

3. Intelligentes Testsystem für ein Speicherpanel gemäß Anspruch 2, wobei
die Anzeigeeinheit (160) die von der ersten Referenzsignalausgabeeinheit (1221) erzeugte erste Referenzspannung so steuert, dass sie einen ersten festen Wert annimmt;
die Anzeigeeinheit (160) die von der zweiten Referenzsignalausgabeeinheit (1222) erzeugte zweite Referenzspannung so steuert, dass sie einen zweiten festen Wert annimmt;
die Anzeigeeinheit (160) die von der dritten Referenzsignalausgabeeinheit (1223) erzeugte dritte Referenzspannung so steuert, dass sie eine voreingestellte Funktion erfüllt.

4. Intelligentes Testverfahren für ein Speicherpanel, das auf das intelligente Testsystem für ein Speicherpanel gemäß einem der Ansprüche 1 bis 3 angewendet wird, umfassend:
S1, Erzeugen von virtuellen Knoten (161), die jeweils den Verbindungsknoten des ersten Array-Schalters (131), des zweiten Array-Schalters (132), dem dritten Array-Schalter (133) und dem vierten Array-Schalter (134) auf einer Anzeige-Schnittstelle der Anzeigeeinheit (160) entsprechend dem ersten Array-Schalter (131), dem zweiten Array-Schalter (132), dem dritten Array-Schalter (133) und dem vierten Array-Schalter (134);
S2, Auslösen der virtuellen Knoten (161), um einen Auslösebefehl zu erzeugen, um Verbindungsleitungen zwischen den virtuellen Knoten (161) auf der Anzeige-Schnittstelle zu erzeugen oder zu löschen, und Steuern entsprechender Verbindungsknoten im ersten Array-Schalter (131), im zweiten Array-Schalter (132), dem dritten Array-Schalter (133) und/oder dem vierten Array-Schalter (134) so zu steuern, dass sie gemäß der Triggeranweisung verbunden oder getrennt werden;
S3, Steuern der Referenzsignalausgabeeinheit (122), um ein Referenzsignal auszugeben, und Erhalten eines dem Referenzsignal entsprechenden Erfassungssignals durch die Ausgabeefassungseinheit (123);
und S4, Erhalten eines Testergebnisses des zu testenden Panels gemäß dem Erfassungssignal.

5. Intelligentes Testverfahren für ein Speicherpanel gemäß Anspruch 4, wobei das Testverfahren ferner umfasst:
A1, Auslösen des virtuellen Knotens (161), der dem zweiten Array-Schalter (132) entspricht, so dass im zweiten Array-Schalter (132) der mit der Stromversorgungseinheit (121) verbundene Verbindungsknoten jeweils mit den mit dem 20. Pin und dem vierten Pin des Panel-Sockels verbundenen Verbindungsknoten verbunden wird und die mit dem 15. Pin und dem 16. Pin des Panel-Sockels verbundenen Verbindungsknoten jeweils elektrisch geerdet werden;
A2, Auslösen des dem vierten Array-Schalter (134) entsprechenden virtuellen Knotens, sodass im vierten Array-Schalter (134) der mit dem 24. Pin der Panel-Buchse verbundene Verbindungsknoten mit dem mit der Ausgangsspannungserfassungseinheit (1231) verbundenen Verbindungsknoten verbunden ist und der mit dem 18. Pin der Panel-Buchse verbundene Verbindungsknoten mit dem mit der Ausgangsstromerfassungseinheit (1232) verbundenen Verbindungspunkt verbunden ist;
A3, Auslösen eines virtuellen Knotens (161), der dem dritten Array-Schalter (133) entspricht, so dass im dritten Array-Schalter (133) der mit dem 22. Pin der Panel-Buchse verbundene Verbindungsknoten mit dem mit der Referenzsignalausgabeeinheit (122) verbundenen Verbindungsknoten verbunden wird;
A4, Einstellen des Referenzsignals, um das entsprechende Spannungserkennungssignal und das Stromerkennungssignal zu erhalten, und Bestimmen, ob das Spannungserkennungssignal und das Stromerkennungssignal eine erste voreingestellte Bedingung erfüllen, wenn ja, Bestimmen, dass das Testergebnis des zu testenden Panels qualifiziert ist, und wenn nicht, Bestimmen, dass das Testergebnis des zu testenden Panels nicht qualifiziert ist.

6. Intelligentes Testverfahren für ein Speicherpanel gemäß Anspruch 5, wobei das Testverfahren ferner umfasst:
A5, Auslösen des virtuellen Knotens, der dem zweiten Array-Schalter entspricht, so dass im zweiten Array-Schalter der mit der Stromversorgungseinheit verbundene Verbindungsknoten und der mit dem ersten Pin der Panel-Buchse verbundene Verbindungsknoten augenblicklich leitend sind;
A6, Einstellen des Referenzsignals, um das entsprechende Spannungserfassungssignal und das Stromerfassungssignal zu erhalten, und Bestimmen, ob das Spannungserfassungssignal und das Stromerfassungssignal eine zweite voreingestellte Bedingung erfüllen, und wenn ja, Bestimmen, dass das Testergebnis des zu testenden Panels qualifiziert ist, und wenn nicht, Bestimmen, dass das Testergebnis des zu testenden Panels nicht qualifiziert ist.

7. Intelligentes Testverfahren für ein Speicherpanel gemäß Anspruch 5, wobei das Testverfahren ferner umfasst:
B5, Auslösen des virtuellen Knotens (161), der dem zweiten Array-Schalter (132) entspricht, so dass im zweiten Array-Schalter (132) der mit der Stromversorgungseinheit (121) verbundene Verbindungsknoten mit dem mit dem zehnten Pin der Panel-Buchse verbundenen Verbindungsknoten verbunden wird;
B6, Erfassen des Spannungserfassungssignals und des Stromerfassungssignals und Bestimmen, ob das Spannungserfassungssignal und das Stromerfassungssignal eine dritte voreingestellte Bedingung erfüllen, und wenn ja, Bestimmen, dass das Testergebnis des zu testenden Panels qualifiziert ist, und wenn nicht, Bestimmen, dass das Testergebnis des zu testenden Panels nicht qualifiziert ist.

8. Intelligentes Testverfahren für ein Speicherpanel gemäß Anspruch 5, wobei das Testverfahren ferner umfasst:
C5, Auslösen des virtuellen Knotens (161), der dem zweiten Array-Schalter (132) entspricht, so dass im zweiten Array-Schalter (132) der mit der Stromversorgungseinheit verbundene Verbindungsknoten mit dem mit dem zwölften Pin der Panel-Buchse verbundenen Verbindungsknoten verbunden wird;
C6, Erfassen des Spannungserkennungssignals und des Stromerkennungssignals und Bestimmen, ob das Spannungserkennungssignal und das Stromerkennungssignal eine vierte voreingestellte Bedingung erfüllen, und wenn ja, Bestimmen, dass das Testergebnis des zu testenden Panels qualifiziert ist, und wenn nicht, Bestimmen, dass das Testergebnis des zu testenden Panels nicht qualifiziert ist.

9. Intelligentes Testverfahren für ein Speicherpanel gemäß Anspruch 5, wobei das Testverfahren ferner umfasst:
D5, Auslösen des virtuellen Knotens (161), der dem zweiten Array-Schalter (132) entspricht, so dass im zweiten Array-Schalter (132) der mit der Stromversorgungseinheit (121) verbundene Verbindungsknoten von dem mit dem vierten Pin der Panel-Buchse verbundenen Verbindungsknoten getrennt wird;
D6, Anpassen des Referenzsignals, um das entsprechende Spannungserfassungssignal und Stromerfassungssignal zu erhalten, und Bestimmen, ob das Spannungserfassungssignal und das Stromerfassungssignal eine fünfte voreingestellte Bedingung erfüllen, wenn ja, Bestimmen, dass das Testergebnis des zu testenden Panels qualifiziert ist, und wenn nicht, Bestimmen, dass das Testergebnis des zu testenden Panels nicht qualifiziert ist.

## Revendications

1. Système de test intelligent pour un panneau de données, comprenant : une unité d'alimentation (121), une unité de sortie de signal de référence (122), une unité de détection de sortie (123), un socle de panneau (110) monté de manière enfichable sur le panneau à tester, un premier commutateur matriciel (131) connecté aux premières broches d'attribut du socle de panneau (110), et un deuxième commutateur matriciel (132) connecté aux deuxièmes broches d'attribut du socle de panneau (110) et à l'unité d'alimentation (121) ; un troisième commutateur matriciel (133) connecté aux troisièmes broches d'attribut du socle de panneau (110) et à l'unité de sortie de signal de référence (122), un quatrième commutateur matriciel (134) connecté aux quatrièmes broches d'attribut du socle de panneau (110) et à l'unité de détection de sortie (123), et une unité de commande (140) connectée respectivement au premier commutateur matriciel (131), au deuxième commutateur matriciel (132), au troisième commutateur matriciel (133) et au quatrième commutateur matriciel (134) ; une unité de communication (150) connectée respectivement à l'unité de sortie de signal de référence (122), à l'unité de détection de sortie (123) et à l'unité de commande (140), et une unité d'affichage (160) connectée à l'unité de communication (150), dans lequel
l'unité d'affichage (160) affiche des nœuds virtuels (161) correspondant à des nœuds de connexion du premier commutateur matriciel (131), du deuxième commutateur matriciel (132), du troisième commutateur matriciel (133) et du quatrième commutateur matriciel (134) respectivement, et l'unité d'affichage (160) génère ou efface des lignes de connexion entre les nœuds virtuels lorsque les nœuds virtuels (161) sont déclenchés, l'unité de commande (140) déclenche les nœuds de connexion correspondants dans le premier commutateur matriciel (131), le deuxième commutateur matriciel (132), le troisième commutateur matriciel (133) et/ou le quatrième commutateur matriciel (134) pour être connectés ou déconnectés lorsque le nœud virtuel (161) est déclenché ;
l'unité d'affichage (160) est aussi utilisée pour la commande de l'unité de sortie de signal de référence (122) pour produire un signal de référence et l'obtention d'un signal de détection correspondant au signal de référence par l'unité de détection de sortie (123) afin d'obtenir un résultat de test du panneau à tester selon le signal de détection,
**caractérisé en ce que** l'unité d'alimentation (121) comprend une première unité d'alimentation (1211) pour la fourniture d'une première tension d'alimentation et une seconde unité d'alimentation (1212) pour la fourniture d'une seconde tension d'alimentation, la première alimentation (1211) et la seconde alimentation (1212) étant respectivement connectées à différents nœuds de connexion du deuxième commutateur matriciel (132) ; et/ou
l'unité de détection de sortie (123) comprend une unité de détection de tension de sortie (1231) pour l'obtention d'un signal de détection de tension du panneau à tester et une unité de détection de courant de sortie (1232) pour l'obtention d'un signal de détection de courant du panneau à tester, dans lequel l'unité de détection de tension de sortie (1231) et l'unité de détection de courant de sortie (1232) sont respectivement connectées à différents nœuds de connexion du quatrième commutateur matriciel (134).

2. Système de test intelligent pour un panneau de données selon la revendication 1, dans lequel
l'unité de sortie de signal de référence (122) comprend une première unité de sortie de signal de référence (1221) pour la génération d'une première tension de référence, une deuxième unité de sortie de signal de référence (1222) pour la génération d'une deuxième tension de référence, et une troisième unité de sortie de référence (1223) pour la génération d'une troisième tension de référence ;
la première unité de sortie de signal de référence (1221), la deuxième unité de sortie de signal de référence (1222), et la troisième unité d'entrée de signal de référence (1223) sont respectivement connectées à différents nœuds de connexion du troisième commutateur matriciel (133).

3. Système de test intelligent pour un panneau de données selon la revendication 2, dans lequel
l'unité d'affichage (160) commande la première tension de référence générée par la première unité de sortie de signal de référence (1221) pour être une première valeur fixe ;
l'unité d'affichage (160) commande la deuxième tension de référence générée par la deuxième unité de sortie de signal de référence (1222) pour être une seconde valeur fixe ;
l'unité d'affichage (160) commande la troisième tension de référence générée par la troisième unité de sortie de signal de référence (1223) pour satisfaire une fonction prédéfinie.

4. Procédé de test intelligent pour un panneau de données, appliqué au système de test intelligent pour un panneau de données selon l'une quelconque des revendications 1 à 3, comprenant :
S1, la génération de nœuds virtuels (161) correspondant respectivement à des nœuds de connexion du premier commutateur matriciel (131), du deuxième commutateur matriciel (132), du troisième commutateur matriciel (133) et du quatrième commutateur matriciel (134) sur une interface d'affichage de l'unité d'affichage (160) selon le premier commutateur matriciel (131), le deuxième commutateur matriciel (132), le troisième commutateur matriciel (133) et le quatrième commutateur matriciel (134) ;
S2, le déclenchement des nœuds virtuels (161) pour générer une instruction de déclenchement, afin de générer ou d'effacer des lignes de connexion entre les nœuds virtuels (161) sur l'interface d'affichage, et la commande de nœuds de connexion correspondants dans le premier commutateur matriciel (131), le deuxième commutateur matriciel (132), le troisième commutateur matriciel (133) et/ou le quatrième commutateur matriciel (134) pour être connectés ou déconnectés selon l'instruction de déclenchement ;
S3, la commande de l'unité de sortie de signal de référence (122) pour produire un signal de référence et l'obtention d'un signal de détection correspondant au signal de référence par l'unité de détection de sortie (123) ;
et S4, l'obtention d'un résultat de test du panneau à tester selon le signal de détection.

5. Procédé de test intelligent pour un panneau de données selon la revendication 4, dans lequel le procédé de test comprend également :
A1, le déclenchement du nœud virtuel (161) correspondant au deuxième commutateur matriciel (132), de sorte que dans le deuxième commutateur matriciel (132), le nœud de connexion connecté à l'unité d'alimentation (121) est respectivement conduit avec les nœuds de connexion connectés à la 20e broche et à la quatrième broche du socle de panneau, et les nœuds de connexion connectés à la 15e broche et à la 16e broche du socle de panneau sont respectivement mis à la terre électriquement ;
A2, le déclenchement du nœud virtuel correspondant au quatrième commutateur matriciel (134), de sorte que dans le quatrième commutateur matriciel (134), le nœud de connexion connecté à la 24e broche du socle de panneau est conduit avec le nœud de connexion connecté à l'unité de détection de tension de sortie (1231), et le nœud de connexion connecté à la 18e broche du socle de panneau est conduit avec le point de connexion connecté à l'unité de détection de courant de sortie (1232) ;
A3, le déclenchement d'un nœud virtuel (161) correspondant au troisième commutateur matriciel (133), de sorte que dans le troisième commutateur matriciel (133), le nœud de connexion connecté à la 22e broche du socle de panneau est conduit avec le nœud de connexion connecté à l'unité de sortie de signal de référence (122) ;
A4, l'ajustement du signal de référence pour obtenir le signal de détection de tension correspondant et le signal de détection de courant, et le fait de déterminer si le signal de détection de tension et le signal de détection de courant satisfont une première condition prédéfinie, si oui, la détermination que le résultat de test du panneau à tester est qualifié, et sinon, la détermination que le résultat de test du panneau à tester n'est pas qualifié.

6. Procédé de test intelligent pour un panneau de données selon la revendication 5, dans lequel le procédé de test comprend également :
A5, le déclenchement du nœud virtuel correspondant au deuxième commutateur matriciel, de sorte que dans le deuxième commutateur matriciel, le nœud de connexion connecté à l'unité d'alimentation et le nœud de connexion connecté à la première broche du socle de panneau sont instantanément conduits ;
A6, l'ajustement du signal de référence pour obtenir le signal de détection de tension correspondant et le signal de détection de courant, et le fait de déterminer si le signal de détection de tension et le signal de détection de courant satisfont une deuxième condition prédéfinie, si oui, la détermination que le résultat de test du panneau à tester est qualifié, et sinon, la détermination que le résultat de test du panneau à tester n'est pas qualifié.

7. Procédé de test intelligent pour un panneau de données selon la revendication 5, dans lequel le procédé de test comprend également :
B5, le déclenchement du nœud virtuel (161) correspondant au deuxième commutateur matriciel (132), de sorte que dans le deuxième commutateur matriciel (132), le nœud de connexion connecté à l'unité d'alimentation (121) est conduit avec le nœud de connexion connecté à la dixième broche du socle de panneau ;
B6, l'obtention du signal de détection de tension et du signal de détection de courant, et le fait de déterminer si le signal de détection de tension et le signal de détection de courant satisfont une troisième condition prédéfinie, si oui, la détermination que le résultat de test du panneau à tester est qualifié, et sinon, la détermination que le résultat de test du panneau à tester n'est pas qualifié.

8. Procédé de test intelligent pour un panneau de données selon la revendication 5, dans lequel le procédé de test comprend également :
C5, le déclenchement du nœud virtuel (161) correspondant au deuxième commutateur matriciel (132), de sorte que dans le deuxième commutateur matriciel (132), le nœud de connexion connecté à l'unité d'alimentation est conduit avec le nœud de connexion connecté à la 12e broche du socle de panneau ;
C6, l'obtention du signal de détection de tension et du signal de détection de courant, et le fait de déterminer si le signal de détection de tension et le signal de détection de courant satisfont une quatrième condition prédéfinie, si oui, la détermination que le résultat de test du panneau à tester est qualifié, et sinon, la détermination que le résultat de test du panneau à tester n'est pas qualifié.

9. Procédé de test intelligent pour un panneau de données selon la revendication 5, dans lequel le procédé de test comprend également :
D5, le déclenchement du nœud virtuel (161) correspondant au deuxième commutateur matriciel (132), de sorte que dans le deuxième commutateur matriciel (132), le nœud de connexion connecté à l'unité d'alimentation (121) est déconnecté du nœud de connexion connecté à la quatrième broche du socle de panneau ;
D6, l'ajustement du signal de référence pour obtenir le signal de détection de tension correspondant et le signal de détection de courant, et le fait de déterminer si le signal de détection de tension et le signal de détection de courant satisfont une cinquième condition prédéfinie, si oui, la détermination que le résultat de test du panneau à tester est qualifié, et sinon, la détermination que le résultat de test du panneau à tester n'est pas qualifié.
